# EUROPEAN PATENT APPLICATION

(11) **EP 4 841 895 A1**
(43) Date of publication of application: **18.11.2026**
(21) Application number: 25738596.3
(22) Date of filing: 10.01.2025
(51) Int. Cl.: H03K 17/081

(54) **RADIO FREQUENCY SWITCH CIRCUIT FOR OPTIMIZING VOLTAGE DISTRIBUTION UNIFORMITY OF STACKED SWITCH TRANSISTORS, AND CHIP**

(30) Priority: 12.01.2024 CN 202410047583
(71) Applicant: Shanghai Vanchip Technologies Co., Ltd., Shanghai 201203 (CN)
(72) Inventor: YANG, Yanmei, Shanghai 201203 (CN); LI, Yanli, Shanghai 201203 (CN); WANG, Feng, Shanghai 201203 (CN)
(74) Representative: Wang, Bo
(86) International application number: PCT/CN2025/071927
(87) International publication number: WO 2025/149069

(57) **Abstract**

Disclosed in the present invention are a radio frequency switch circuit for optimizing voltage distribution uniformity of stacked switch transistors, and a chip. The radio frequency switch circuit is formed by linking and stacking sources and drains of N switch transistors, wherein N is a positive integer, and N≥3; the source end and the drain end of each switch transistor are connected by means of a source-drain bias resistor; the bulk end of each switch transistor is connected to a bulk end bias resistor; when the N bulk end bias resistors are sequentially connected in series, the head end is connected to a bulk end bias voltage source; and series diode branches connected to the bulk ends of even-numbered stages of switch transistors are connected to the source ends and drain ends of respective switch transistors, and series diode branches connected to the bulk ends of odd-numbered stages of switch transistors are connected to the source ends and drain ends of respective adjacent switch transistors. When the radio frequency switch circuit is turned off, bulk end leakage currents generated by the stages of switch transistors flow into a radio frequency main path by means of the series diode branches and cancel each other out, thereby realizing the optimization of the voltage distribution uniformity of the stacked switch transistors.

## Description

### BACKGROUND

### Technical Field

The present invention belongs to the technical field of radio frequency integrated circuits, and relates to a radio frequency switch circuit with an optimized voltage distribution uniformity of stacked switch transistors, and also a chip including the radio frequency switch circuit and a corresponding electronic device.

### Related Art

As one of important parts of a radio frequency front-end module, a radio frequency switch circuit is configured to accurately switch a transmission path of a radio frequency signal and select a corresponding radio frequency path; to implement receiving and transmission of the radio frequency signal in a case that wireless communication systems share an antenna; and further to apply for antenna resistance tuning, thereby improving antenna efficiency. In the prior art, the radio frequency switch circuit usually operates in a working scenario of high voltage and high power and needs to bear relatively large voltage fluctuation. A method for improving power withstanding and voltage withstanding capabilities of the radio frequency switch circuit generally is a stacked structure of switch transistors, that is, the radio frequency switch circuit is formed by connecting multiple stages of switch transistors in series. However, the radio frequency switch circuit with this stack structure has an imbalanced voltage distribution, so that a large quantity of harmonics are generated, thereby limiting the power withstanding and voltage withstanding capabilities of the radio frequency switch circuit. Thus, a signal processing capability of a radio frequency transceiver is affected, resulting in degradation of communication quality of a communication system, and antenna efficiency is reduced when the radio frequency switch circuit is used for antenna resistance tuning.

### SUMMARY

A primary technical problem to be solved in the present invention is to provide a radio frequency switch circuit with an optimized voltage distribution uniformity of stacked switch transistors.

Another technical problem to be resolved in the present invention is to provide a chip including the radio frequency switch circuit and a corresponding electronic device.

To achieve the above objectives, the present invention adopts the following technical solutions.

According to a first aspect of embodiments of the present invention, a radio frequency switch circuit with an optimized voltage distribution uniformity of stacked switch transistors is provided. The radio frequency switch circuit is composed of N switch transistors stacked in series, with the source/drain terminals of adjacent transistors connected in cascade, N is a positive integer, and N ≥ 3.

The source terminal and the drain terminal of each of the switch transistors are connected through a source-drain bias resistor. A body terminal of each of the switch transistors is connected to a body terminal bias resistor, the N body terminal bias resistors are sequentially connected in series, and a head terminal of the N body terminal bias resistors is connected to a body terminal bias voltage source.

The body terminal of a first-stage switch transistor is connected to the drain terminal of a second-stage switch transistor through one or two branches each composed of X series-connected diodes.

The body terminal of a middle even-numbered-stage switch transistor is connected to the source terminal and the drain terminal of the middle even-numbered-stage switch transistor through separate branches each composed of X or Y series-connected diodes. The body terminal of a middle odd-numbered-stage switch transistor is connected to the source terminal of a preceding-stage switch transistor and the drain terminal of a succeeding-stage switch transistor through separate branches each composed of X series-connected diodes.

The body terminal of an N^{th}-stage switch transistor is connected to the source terminal of an (N-1)^{th}-stage switch transistor through one or two branches each composed of X series-connected diodes, where
X and Y are both positive integers, X ≥ 1 and Y ≤ X. A positive terminal of each of the branches of series-connected diodes is connected to the body terminal of a corresponding switch transistor.

Preferably, when the radio frequency switch circuit is in a turned-off state, when a voltage difference between the source terminal and the drain terminal of a switch transistor reaches a turn-on voltage of corresponding branches of series-connected diodes, the branches of series-connected diodes are turned on as low-resistance paths, and a body terminal leakage current of the switch transistor flows to the source terminal and the drain terminal of the switch transistor or flows to the source terminal of an adjacent switch transistor and the drain terminal of another adjacent switch transistor through the low-resistance path and then is canceled out, thereby preventing deterioration of performance of the radio frequency switch circuit caused after a body terminal bias voltage of the switch transistor is raised, and optimizing the voltage distribution uniformity of the stacked switch transistors.

Preferably, when the radio frequency switch circuit is in a turned-on state, voltages at two terminals of the series diode branch are equal, and the series diode branch is short-circuited and in an open-circuited state.

Preferably, a gate terminal of each of the switch transistors is connected to a gate terminal bias resistor, and after N gate terminal bias resistors are sequentially connected in series, a head terminal is connected to a gate terminal bias voltage source.

Preferably, when a voltage difference between the source terminal and the drain terminal of an odd-numbered-stage switch transistor satisfies a turn-on condition for the branches of series-connected diodes for the body terminal of the odd-numbered-stage switch transistor, but a voltage difference between the source terminal and the drain terminal of an even-numbered-stage switch transistor does not satisfy a turn-on condition for the branches of series-connected diodes for the body terminal of the even-numbered-stage switch transistor, the branches of series-connected diodes for the body terminal of the odd-numbered-stage switch transistor are first turned on, and a body terminal leakage current of the even-numbered-stage switch transistor flows through a resistor connected to the body terminal and then flows to a source-drain node of the radio frequency switch transistor through the branches of series-connected diodes for the body terminal of the odd-numbered-stage switch transistor.

Preferably, when a voltage difference between the source terminal and the drain terminal of the odd-numbered-stage transistor satisfies a turn-on condition for the branches of series-connected diodes for the body terminal of the odd-numbered-stage transistor, and a voltage difference between the source terminal and the drain terminal of the even-numbered-stage transistor satisfies a turn-on condition for the branches of series-connected diodes for the body terminal of the even-numbered-stage transistor, the branches of series-connected diodes for the body terminals of the odd-numbered-stage switch transistor and the even-numbered-stage switch transistor are simultaneously turned on, and the body terminal leakage currents of the switch transistors flow to the source-drain nodes of the radio frequency switch transistors through low-resistance paths.

Preferably, a quantity of the diodes in each of the branches of series-connected diodes for the body terminal of a switch transistor is determined by a turn-on voltage of the branch of series-connected diodes and a voltage difference between the source terminal and the drain terminal of the switch transistor.

According to a second aspect of embodiments of the present invention, an integrated circuit chip is provided. The integrated circuit chip includes the foregoing radio frequency switch circuit with an optimized voltage distribution uniformity of stacked switch transistors.

According to a third aspect of embodiments of the present invention, an electronic device is provided. The electronic device includes the foregoing radio frequency switch circuit with an optimized voltage distribution uniformity of stacked switch transistors.

Compared with the prior art, the radio frequency switch circuit with an optimized voltage distribution uniformity of stacked switch transistors provided in the present invention, through a technical solution in which the branches of series-connected diodes are arranged at the body terminal of each of the stages of switch transistors, and the body terminal leakage currents generated by each of the stages of switch transistors are introduced to a radio frequency main path and cancel each other out, achieves optimization of a voltage distribution uniformity of stacked switch transistors and further improves linearization and a power withstanding capability of a radio frequency switch circuit. Therefore, the radio frequency switch circuit with an optimized voltage distribution uniformity of stacked switch transistors provided in the present invention has beneficial effects, such as a skillful and proper structure design, low design costs, and excellent circuit performance.

### BRIEF DESCRIPTION OF THE DRAWINGS

FIG. 1 is a schematic circuit diagram of a typical radio frequency switch circuit in the prior art;
FIG. 2 is a schematic circuit diagram of a radio frequency switch circuit with an optimized voltage distribution uniformity of stacked switch transistors according to an embodiment of the present invention;
FIG. 3 is a comparison diagram of simulation tests of second-order harmonics of a radio frequency switch circuit of a prior-art solution and a technical solution of the present invention according to an embodiment of the present invention;
FIG. 4 is a comparison diagram of simulation tests of third-order harmonics of a radio frequency switch circuit of a prior-art solution and a technical solution of the present invention according to an embodiment of the present invention;
FIG. 5 is a comparison diagram of simulation tests of voltages between a source terminal and a drain terminal of a radio frequency switch circuit of a prior-art solution and a technical solution of the present invention according to an embodiment of the present invention; and
FIG. 6 is a schematic diagram of an electronic device using the radio frequency switch circuit according to embodiments of the present invention.

### DETAILED DESCRIPTION

Technical content of the present invention is described in detail below with reference to the accompanying drawings and specific embodiments.

For convenience of comprehension and description, a brief description of a radio frequency switch circuit in a prior-art solution is first described below, and on this basis, specific technical solutions of embodiments of the present invention in detail are described.

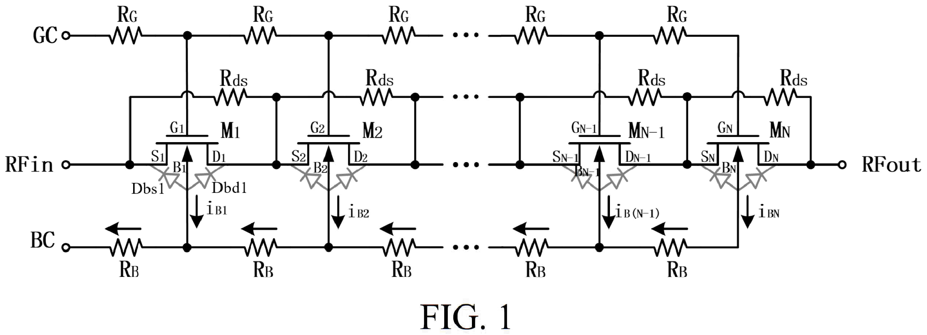

A typical radio frequency switch circuit in the prior art is shown in FIG. 1. The radio frequency switch circuit is formed by N switch transistors M₁ to M_{N} stacked in series (N is a positive integer and N ≥ 3). The source terminal and the drain terminal of each of the switch transistors are connected through a source-drain bias resistor Rds. A gate terminal of each of the switch transistors is connected to a gate terminal bias resistor R_{G}, the N gate terminal bias resistors R_{G} are sequentially connected in series, and a head terminal GC of the N gate terminal bias resistors is connected to a gate terminal bias voltage source Vg. A body terminal of each of the switch transistors is connected to a body terminal bias resistor R_{B}, the N body terminal bias resistors R_{B} are sequentially connected in series, and a head terminal BC of the N body terminal bias resistors is connected to a body terminal bias voltage source Vb.

Usually, when the radio frequency switch circuit is turned on, a gate terminal bias voltage Vg is 2.5 V, and a body terminal bias voltage Vb is 0 V. When the radio frequency switch circuit is turned off, the gate terminal bias voltage Vg is -2.5 V, and the body terminal bias voltage Vb is -2.5 V. A turned-on state and a turned-off state of the radio frequency switch circuit are controlled by changing voltage values of the gate terminal bias voltage Vg and the body terminal bias voltage Vb. The source-drain bias resistor Rds provides a direct current turned-off potential for a switch transistor that is turned off, to prevent charge accumulation on a source-drain node of the switch transistor that causes the switch transistor to break down in advance.

Due to a structure of a switch transistor element, a parasitic diode exists between a body terminal and a source terminal and a drain terminal of each switch transistor. For example, in FIG. 1, a parasitic diode Dbs1 exists between a body terminal B1 and a source terminal S1 of a first-stage switch transistor M1, and a parasitic diode Dbd1 exists between the body terminal B1 and a drain terminal D1. When the radio frequency switch circuit is in a turned-on state, each switch transistor enables a short circuit of a parasitic diode existing therein. That is, the existence of the parasitic diode has no impact on turned-on resistance of a path of a radio frequency switch circuit that is in the turned-on state.

When the radio frequency switch circuit is in the turned-off state, especially a radio frequency switch circuit configured for antenna resistance tuning is usually in a turned-off state, a voltage difference occurs between a source terminal and a drain terminal of a switch transistor of a stacked series structure, and the voltage difference is larger if a power value of a radio frequency signal is higher. When the voltage difference increases to a degree, the parasitic diode between the body terminal and the source terminal or between the body terminal and the drain terminal is turned on to generate a body terminal leakage current iB. The body terminal leakage current iB may generate voltage drop on the body terminal bias resistor R_{B}, thereby raising the body terminal bias voltage. A raised level of the body terminal bias voltage is closely related to a quantity of series stages of switch transistors. When the quantity of series stages of the switch transistors is greater, a total body terminal leakage current flowing through a body terminal bias resistor R_{B} of a first-stage switch transistor M1 is greater, and the raised level of the body terminal bias voltage is greater. After the body terminal bias voltage of the switch transistor is raised, a large amount of harmonics is rapidly generated by a radio frequency switch circuit, with more significant nonlinearity. In addition, an imbalanced voltage distribution in the switch transistor of a stacked series structure is exacerbated, the switch transistor is more likely to break down, and a power withstanding capability of the radio frequency switch circuit is greatly reduced.

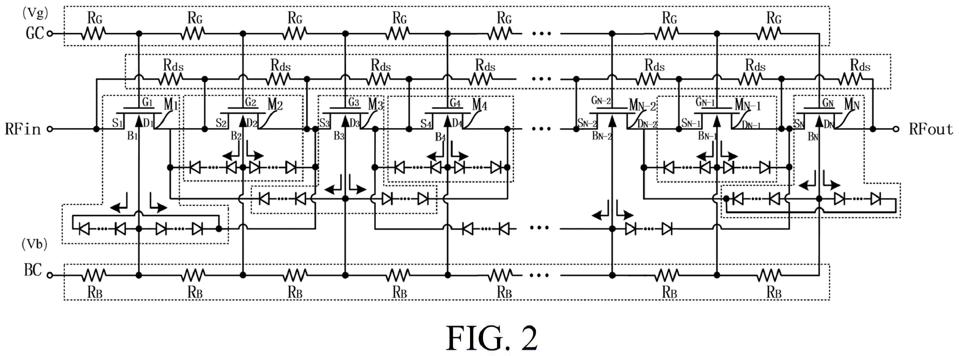

To resolve the foregoing problem existing in the prior art, embodiments of the present invention provide a radio frequency switch circuit with an optimized voltage distribution uniformity of stacked switch transistors. As shown in FIG. 2, the radio frequency switch circuit is formed by N switch transistors M₁ to M_{N} stacked in series (N is a positive integer and N ≥ 3). The source terminal and the drain terminal of each of the switch transistors are connected through the source-drain bias resistor Rds. A gate terminal of each of the switch transistors is connected to a gate terminal bias resistor R_{G}, the N gate terminal bias resistors R_{G} are sequentially connected in series, and a head terminal GC of the N gate terminal bias resistors is connected to a gate terminal bias voltage source Vg. A body terminal of each of the switch transistors is connected to a body terminal bias resistor R_{B}, the N body terminal bias resistors R_{B} are sequentially connected in series, and a head terminal BC of the N body terminal bias resistors is connected to a body terminal bias voltage source Vb. In addition, the body terminal of a first-stage switch transistor is further connected to the drain terminal of a second-stage switch transistor through two branches each composed of X series-connected diodes (X is a positive integer and X ≥ 1). The body terminal of a middle even-numbered-stage switch transistor is connected to the source terminal and the drain terminal of the middle even-numbered-stage switch transistor through separate branches each composed of X series-connected diodes. The body terminal of a middle odd-numbered-stage switch transistor is connected to the source terminal of a preceding-stage switch transistor and the drain terminal of a succeeding-stage switch transistor through separate branches each composed of X series-connected diodes. The body terminal of an N^{th}-stage (a last stage) switch transistor is connected to the source terminal of an (N-1)^{th}-stage switch transistor through the one or two branches each composed of X series-connected diodes. A positive terminal of each of the branches composed of X series-connected diodes is connected to the body terminal of a corresponding switch transistor.

When the radio frequency switch circuit is in a turned-on state, because a source terminal voltage V_{S} and a drain terminal voltage V_{D} of each switch transistor are the same, and a body terminal voltage V_{B} = (V_{S} + V_{D})/2 + Vb, where a body terminal bias voltage Vb is 0 volt, the body terminal voltage is also the same as a voltage between a source terminal and a drain terminal. Therefore, each branch composed of X series-connected diodes is equivalently shorted and is in a short-circuited state, and turned-on resistance of a path of a radio frequency signal is not affected.

However, when the radio frequency switch circuit is in a turned-off state, when a voltage difference between a source terminal and a drain terminal of a switch transistor having a stacked series structure reaches a turn-on voltage of the branches of series-connected diodes, the branch composed of X series-connected diodes is in a turned-on state. Compared with a bias network formed by body terminal bias resistors R_{B}, the branch composed of series-connected diodes is a low-resistance path. Therefore, the body terminal leakage currents iB generated because the parasitic diode between the body terminal and the source terminal or between the body terminal and the drain terminal is turned on due to an increase in the voltage difference between the source terminal and the drain terminal of the switch transistor no longer flow through a bias network formed by the body terminal bias resistors R_{B}, but flow to the source terminal and the drain terminal of the switch transistor itself or flows to source terminals and drain terminals of adjacent switch transistors through the branch composed of series-connected diodes. In addition, the body terminal leakage currents iB cancel each other after flowing through the bias resistors Rds between the source terminals and the drain terminals. Therefore, performance of the radio frequency switch circuit is not deteriorated due to raising of the body terminal bias voltage, voltage distribution uniformity of stacked switch transistors is optimized, and generation of a large amount of harmonics is prevented, thereby improving linearization of a radio frequency switch circuit and greatly improving a power withstanding capability of the radio frequency switch circuit.

When a voltage between a source terminal and a drain terminal of a switch transistor is relatively small, that is, the voltage difference between the source terminal and the drain terminal of an odd-numbered-stage switch transistor satisfies a turn-on condition for the branches of series diodes for the body terminal of the odd-numbered-stage switch transistor, but a voltage difference between the source terminal and the drain terminal of an even-numbered-stage switch transistor does not satisfy a turn-on condition for the branches of series-connected diodes for the body terminal of the even-numbered-stage switch transistor, the branches of series-connected diodes for the body terminal of the odd-numbered-stage switch transistor are first turned on, and a body terminal leakage current of the even-numbered-stage switch transistor flows through a resistor R_{B} connected to the body terminal and then flows to a source-drain node of the radio frequency switch transistor through the branches of series-connected diodes for the body terminal of the odd-numbered-stage switch transistor.

When the voltage between the source terminal and the drain terminal of the switch transistor is relatively large, that is, the voltage difference satisfies the turn-on conditions for the branches of series diodes for the body terminals of the odd-numbered-stage switch transistor and the even-numbered-stage switch transistor, the branches of series-connected diodes for the body terminals of the odd-numbered-stage switch transistor and the even-numbered-stage switch transistor are simultaneously turned on. A leakage path is additionally added to the series diode branch for the body terminal of the even-numbered-stage switch transistor, and the body terminal leakage current of the odd-numbered-stage switch transistor may also flow through the series diode branch for the body terminal of the even-numbered-stage switch transistor through the resistor R_{B} connected to the body terminal, and further flow to the source-drain node of the radio frequency switch transistor, to prevent the branches of series-connected diodes of the odd-numbered-stage switch transistor from being broken down.

In an embodiment of the present invention, a body terminal of a first-stage switch transistor and a body terminal of an N^{th}-stage switch transistor (a last stage) of a radio frequency switch circuit are both connected to a drain terminal or a source terminal of an adjacent switch transistor through two branches each composed of X series-connected diodes. In another embodiment of the present invention, the body terminal of the first-stage switch transistor and the body terminal of the N^{th}-stage switch transistor (the last stage) of the radio frequency switch circuit may also be connected to the drain terminal or the source terminal of the adjacent switch transistor through a branch composed of X series-connected diodes, which does not affect optimized performance of a circuit.

In an embodiment of the present invention, in the radio frequency switch circuit, both the branches of series-connected diodes connected to the body terminals of the odd-numbered-stage switch transistors and the branches of series-connected diodes connected to the body terminals of the even-numbered-stage switch transistors are each composed of X series-connected diodes. In another embodiment of the present invention, based on a requirement for a radio frequency circuit, a technical solution in which the branches of series-connected diodes connected to the body terminals of the odd-numbered-stage switch transistors are composed of X series-connected diodes, and the branches of series-connected diodes connected to the body terminals of the even-numbered-stage switch transistors are composed of Y series-connected diodes may be used, where Y is a positive integer, and Y ≤ X.

It needs to be noted that in the branch composed of X series-connected diodes, a value of the quantity X of the diodes is usually determined by a turn-on voltage of the branch composed of X series-connected diodes and the voltage difference between the source terminal and the drain terminal of the switch transistor.

In a radio frequency switch circuit using a prior-art solution, when a quantity of stages of in-series switch transistor is greater, a total body terminal leakage current flowing through a body terminal bias resistor R_{B} of a first-stage switch transistor M1 is greater, so that a raised level of a body terminal bias voltage thereof is greater, and nonlinearity of the radio frequency switch circuit is more significant. The technical effect implemented by embodiments of the present invention is just the opposite. In embodiments of the present invention, the radio frequency switch circuit is composed of N switch transistors stacked in series, with the source/drain terminals of adjacent transistors connected in cascade. The larger the quantity N is, the more significant are the optimized voltage distribution uniformity and linearization performance of the stacked switch transistors, more significantly improving a power withstanding capability.

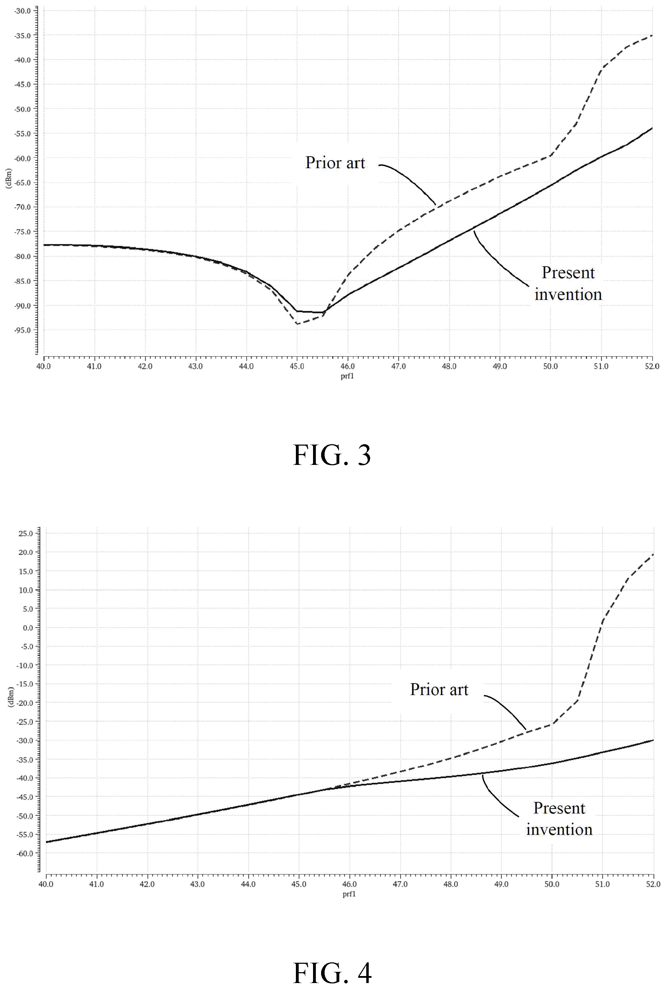

To verify excellent performance of the radio frequency switch circuit with an optimized voltage distribution uniformity of stacked switch transistors provided in embodiments of the present invention, the inventor performs a plurality of performance simulation and comparison tests on the radio frequency switch circuit and a radio frequency switch circuit using the prior-art solution. Test results are shown in FIG. 3, FIG. 4, and FIG. 5.

FIG. 3 shows simulation test curves of second-order harmonics of the radio frequency switch circuits. A horizontal coordinate is input power, a vertical coordinate is a second-order harmonic, and a unit is dBm. It can be seen from FIG. 3 that, comparing the radio frequency switch circuit using the prior-art solution with the radio frequency switch circuit provided in this embodiment of the present invention, when the input power is relatively low, the second-order harmonics generated by the two radio frequency switch circuits are basically the same. However, as the input power increases, the second-order harmonics generated by the radio frequency switch circuit provided in this embodiment of the present invention are significantly less than the second-order harmonics generated by the radio frequency switch circuit using the prior-art solution, and second-order harmonic performance is greatly optimized.

FIG. 4 shows simulation test curves of third-order harmonics of the radio frequency switch circuits. A horizontal coordinate is the input power, the vertical coordinate is the third-order harmonic, and the unit is dBm. It can be seen from FIG. 4 that, comparing the radio frequency switch circuit using the prior-art solution with the radio frequency switch circuit provided in this embodiment of the present invention, when the input power is relatively low, the third-order harmonics generated by the two radio frequency switch circuits are basically the same. However, as the input power increases, the third-order harmonic generated by the radio frequency switch circuit provided in embodiments of the present invention is significantly less than the third-order harmonic generated by the radio frequency switch circuit using the prior-art solution, and third-order harmonic performance is greatly optimized.

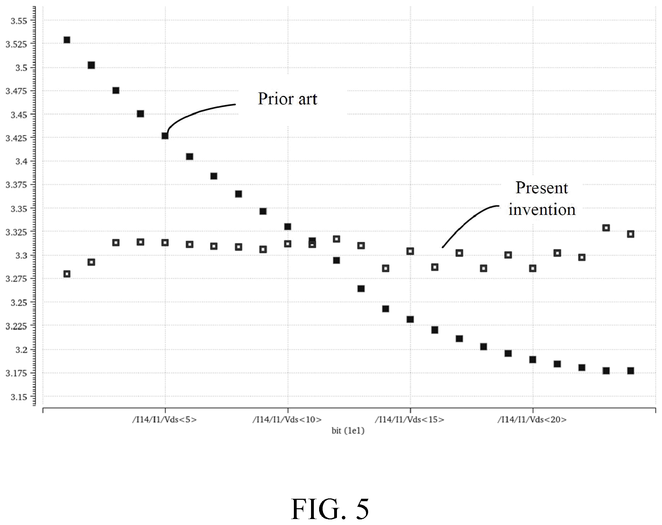

FIG. 5 shows a result of a simulation test of a voltage between a source terminal and a drain terminal of a radio frequency switch circuit. The tested circuit is a radio frequency switch circuit formed by stacking 24 switch transistors in series, and test input power is 48 dBm. In FIG. 5, the abscissa represents stages of switch transistors (from a 1^{st} stage to a 24^{th} stage), the ordinate represents actual voltage values of voltages Vds between source terminals and drain terminals of switch transistors, and a unit is volt (V). As can be seen from FIG. 5, comparing the radio frequency switch circuit provided in embodiments of the present invention with the radio frequency switch circuit using the prior-art solution, in the radio frequency switch circuit using the prior-art solution, differences between the voltages Vds between the source terminals and drain terminals the stages of switch transistors are relatively large, and the maximum difference between Vds is approximately 0.35 V. However, in the radio frequency switch circuit provided in embodiments of the present invention, the voltages Vds between the source terminals and the drain terminals of the stages of switch transistors are relatively balanced, and the maximum difference between Vds is approximately 0.05 V. This indicates that the radio frequency switch circuit provided in embodiments of the present invention can well optimize voltage distribution uniformity of stacked switch transistors and prevent generation of a large amount of harmonics, thereby improving linearization and a power withstanding capability.

The structure and the working principle of the radio frequency switch circuit with an optimized voltage distribution uniformity of stacked switch transistors provided in the present invention are described in detail above. Based on the radio frequency switch circuit, an embodiment of the present invention further provides an integrated circuit chip. The integrated circuit chip includes the foregoing radio frequency switch circuit with an optimized voltage distribution uniformity of stacked switch transistors and is used as an important part of a radio frequency front-end module in a wireless communication system. The integrated circuit chip is configured to accurately switch a transmission path of a radio frequency signal and select a corresponding radio frequency path; or to implement receiving and transmission of the radio frequency signal in a case that wireless communication systems share an antenna; and further to apply for antenna resistance tuning, thereby improving antenna efficiency. A specific structure of the radio frequency switch circuit with an optimized voltage distribution uniformity of stacked switch transistors in the integrated circuit chip is not described in detail herein.

In addition, the radio frequency switch circuit with an optimized voltage distribution uniformity of stacked switch transistors provided in the present invention may further be used in an electronic device and used as an important part of a communication assembly. The electronic device mentioned herein refers to a computer device that may be used in a mobile environment and supports a plurality of communication modes such as GSM, EDGE, CDMA, TD_SCDMA, WCDMA, TDD_LTE, FDD_LTE, and NR. The computer device includes a mobile phone, a notebook computer, a tablet computer, an on-board computer, and the like. In addition, the technical solution provided in the present invention is also suitable for other occasions in which a radio frequency integrated circuit is applied, such as a communication base station and an intelligent connected vehicle.

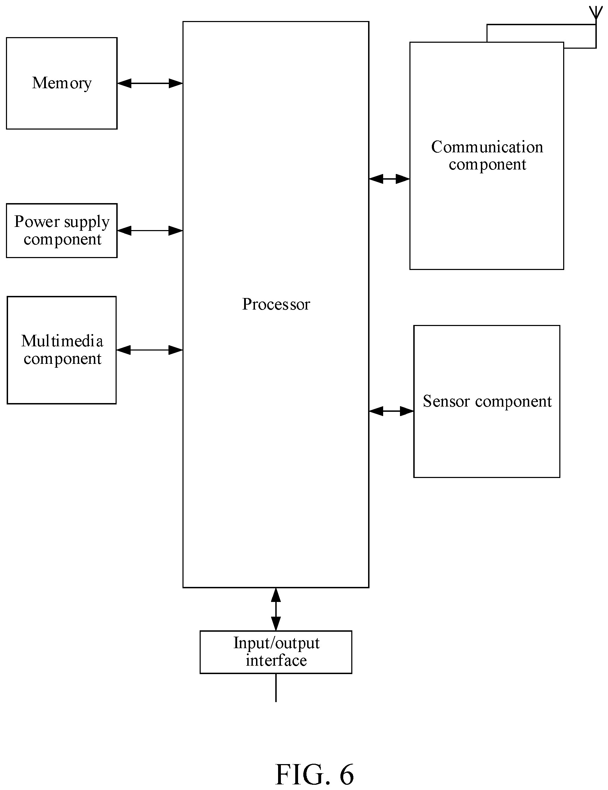

As shown in FIG. 6, the electronic device at least includes a processor, a memory, and a communication component, and may further include a sensor component, a power supply component, a multimedia component, and an input/output interface according to the actual need. The memory, the communication component, the sensor component, the power supply component, the multimedia component, and the input/output interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphics processing unit (GPU), a field-programmable gate array (FPGA), an application-specific integrated circuit (ASIC), a digital signal processing (DSP) chip, or the like. Another communication component, sensor component, power supply component, multimedia component, and the like may be implemented through a general-purpose component. Details are not described herein.

In conclusion, compared with the prior art, the radio frequency switch circuit with an optimized voltage distribution uniformity of stacked switch transistors provided in the present invention, through a technical solution in which the branches of series-connected diodes are arranged at the body terminal of each of the stages of switch transistors, and the body terminal leakage currents generated by each of the stages of switch transistors are introduced to a radio frequency main path and cancel each other out, achieves optimization of a voltage distribution uniformity of stacked switch transistors and further improves linearization and a power withstanding capability of a radio frequency switch circuit. Therefore, the radio frequency switch circuit with an optimized voltage distribution uniformity of stacked switch transistors provided in the present invention has beneficial effects, such as a skillful and proper structure design, low design costs, and excellent circuit performance.

It needs to be noted that the terms "first" and "second" are used for descriptive purposes only and should not be construed as indicating or implying relative importance or implicitly indicating a number of technical features indicated. Therefore, features defined by "first" and "second" may explicitly or implicitly include one or more such features. In the descriptions of the present invention, "a plurality of" means two or more, unless otherwise definitely and specifically defined.

The radio frequency switch circuit with an optimized voltage distribution uniformity of stacked switch transistors and the chip provided in the present invention are described in detail above. For a person of ordinary skill in the art, any apparent change made to the present invention without departing from the essential content of the present invention constitutes infringement of the patent right of the present invention and bears a corresponding legal responsibility.

## Claims

1. A radio frequency switch circuit with an optimized voltage distribution uniformity of stacked switch transistors, wherein the radio frequency switch circuit is composed of N switch transistors stacked in series, with the source/drain terminals of adjacent transistors connected in cascade, N is a positive integer, and N ≥ 3, wherein
the source terminal and the drain terminal of each of the switch transistors are connected through a source-drain bias resistor; a body terminal of each of the switch transistors is connected to a body terminal bias resistor, the N body terminal bias resistors are sequentially connected in series, and a head terminal of the N body terminal bias resistors is connected to a body terminal bias voltage source;
the body terminal of a first-stage switch transistor is connected to the drain terminal of a second-stage switch transistor through one or two branches each composed of X series-connected diodes;
the body terminal of a middle even-numbered-stage switch transistor is connected to the source terminal and the drain terminal of the middle even-numbered-stage switch transistor through separate branches each composed of X or Y series-connected diodes; the body terminal of a middle odd-numbered-stage switch transistor is connected to the source terminal of a preceding-stage switch transistor and the drain terminal of a succeeding-stage switch transistor through separate branches each composed of X series-connected diodes; and
the body terminal of an N^{th}-stage switch transistor is connected to the source terminal of an (N-1)^{th}-stage switch transistor through one or two branches each composed of X series-connected diodes; wherein
X and Y are both positive integers, X ≥ 1, and Y ≤ X; and a positive terminal of each of the branches of series-connected diodes is connected to the body terminal of a corresponding switch transistor.

2. The radio frequency switch circuit with an optimized voltage distribution uniformity of stacked switch transistors according to claim 1, wherein
when the radio frequency switch circuit is in a turned-off state, when a voltage difference between the source terminal and the drain terminal of a switch transistor reaches a turn-on voltage of corresponding branches of series-connected diodes, the branches of series-connected diodes are turned on as low-resistance paths, and a body terminal leakage current of the switch transistor flows to the source terminal and the drain terminal of the switch transistor or flows to the source terminal of an adjacent switch transistor and the drain terminal of another adjacent switch transistor through the low-resistance paths and is then canceled out.

3. The radio frequency switch circuit with an optimized voltage distribution uniformity of stacked switch transistors according to claim 1, wherein
when the radio frequency switch circuit is in a turned-on state, each of the branches of series-connected diodes is short-circuited because of equal voltages at two terminals of the branch of series-connected diodes and is thus in an open-circuit state.

4. The radio frequency switch circuit with an optimized voltage distribution uniformity of stacked switch transistors according to claim 2 or 3, wherein
a gate terminal of each of the switch transistors is connected to a gate terminal bias resistor, and the N gate terminal bias resistors are sequentially connected in series, and a head terminal of the N gate terminal bias resistors is connected to a gate terminal bias voltage source.

5. The radio frequency switch circuit with an optimized voltage distribution uniformity of stacked switch transistors according to claim 1, wherein
when a voltage difference between the source terminal and the drain terminal of an odd-numbered-stage switch transistor satisfies a turn-on condition for the branches of series-connected diodes for the body terminal of the odd-numbered-stage switch transistor, but a voltage difference between the source terminal and the drain terminal of an even-numbered-stage switch transistor does not satisfy a turn-on condition for the branches of series-connected diodes for the body terminal of the even-numbered-stage switch transistor, the branches of series-connected diodes for the body terminal of the odd-numbered-stage switch transistor are first turned on, and a body terminal leakage current of the even-numbered-stage switch transistor flows through a resistor connected to the body terminal and then flows to a source-drain node of the radio frequency switch transistor through the branches of series-connected diodes for the body terminal of the odd-numbered-stage switch transistor.

6. The radio frequency switch circuit with an optimized voltage distribution uniformity of stacked switch transistors according to claim 1, wherein
when a voltage difference between the source terminal and the drain terminal of the odd-numbered-stage transistor satisfies a turn-on condition for the branches of series-connected diodes for the body terminal of the odd-numbered-stage transistor, and a voltage difference between the source terminal and the drain terminal of the even-numbered-stage transistor satisfies a turn-on condition for the branches of series-connected diodes for the body terminal of the even-numbered-stage transistor, the branches of series-connected diodes for the body terminals of the odd-numbered-stage switch transistor and the even-numbered-stage switch transistor are simultaneously turned on, and the body terminal leakage currents of the switch transistors flow to the source-drain nodes of the radio frequency switch transistors through low-resistance paths.

7. The radio frequency switch circuit with an optimized voltage distribution uniformity of stacked switch transistors according to claim 1, wherein
a quantity of the diodes in each of the branches of series-connected diodes for the body terminal of a switch transistor is determined by a turn-on voltage of the branch of series-connected diodes and a voltage difference between the source terminal and the drain terminal of the switch transistor.

8. A radio frequency switch circuit with an optimized voltage distribution uniformity of stacked switch transistors, wherein the radio frequency switch circuit is composed of N switch transistors stacked in series, with the source/drain terminals of adjacent transistors connected in cascade, N is a positive integer, and N ≥ 3, wherein
the source terminal and the drain terminal of each of the switch transistors are connected through a source-drain bias resistor; a body terminal of each of the switch transistors is connected to a body terminal bias resistor, the N body terminal bias resistors are sequentially connected in series, and a head terminal of the N body terminal bias resistors is connected to a body terminal bias voltage source;
the body terminal of a first-stage switch transistor is connected to the drain terminal of a second-stage switch transistor through one or two branches each composed of X series-connected diodes;
the body terminal of a middle even-numbered-stage switch transistor is connected to the source terminal and the drain terminal of the middle even-numbered-stage switch transistor through separate branches each composed of X series-connected diodes; or connected to the source terminal and the drain terminal of the middle even-numbered-stage switch transistor through separate branches each composed of Y series-connected diodes;
the body terminal of a middle odd-numbered-stage switch transistor is connected to the source terminal of a preceding-stage switch transistor and the drain terminal of a succeeding-stage switch transistor through separate branches each composed of X series-connected diodes; and
the body terminal of an N^{th}-stage switch transistor is connected to the source terminal of an (N-1)^{th}-stage switch transistor through one or two branches each composed of X series-connected diodes;
X and Y are both positive integers, X ≥ 1, and Y ≤ X; and a positive terminal of each of the branches of series-connected diodes is connected to the body terminal of a corresponding switch transistor; wherein when the radio frequency switch circuit is in a turned-off state,
when a voltage difference between the source terminal and the drain terminal of an odd-numbered-stage switch transistor satisfies a turn-on condition for the branches of series-connected diodes for the body terminal of the odd-numbered-stage switch transistor, the branches of series-connected diodes for the body terminal of the odd-numbered-stage switch transistor are turned on, and a body terminal leakage current of the even-numbered-stage switch transistor flows through a body terminal bias resistor and then flows to a source-drain node of the switch transistor through the branches of series-connected diodes for the body terminal of the odd-numbered-stage switch transistor;
when a voltage difference between the source terminal and the drain terminal of the odd-numbered-stage transistor satisfies a turn-on condition for the branches of series-connected diodes for the body terminal of the odd-numbered-stage transistor, and a voltage difference between the source terminal and the drain terminal of the even-numbered-stage transistor satisfies a turn-on condition for the branches of series-connected diodes for the body terminal of the even-numbered-stage transistor, all of the branches of series-connected diodes are simultaneously turned on, and the body terminal leakage currents of the switch transistors flow to the source-drain nodes of the switch transistors through low-resistance paths; and
the body terminal leakage currents flow through the source-drain bias resistors and are then canceled out.

9. An integrated circuit chip, comprising the radio frequency switch circuit with an optimized voltage distribution uniformity of stacked switch transistors according to any one of claims 1 to 8.

10. An electronic device, comprising the radio frequency switch circuit with an optimized voltage distribution uniformity of stacked switch transistors according to any one of claims 1 to 8.
